# EUROPEAN PATENT APPLICATION

(11) **EP 4 395 112 A1**
(43) Date of publication of application: **03.07.2024**
(21) Application number: 23190464.0
(22) Date of filing: 09.08.2023
(51) Int. Cl.: H02J 7/00, H01M 10/42, H01M 10/44, H01M 10/46, H01M 10/48, H02J 50/10, H02J 50/40, H02J 50/80, B60L 3/00

(54) **METHODS AND APPARATUSES WITH BI-DIRECTIONAL WIRELESS POWER TRANSFER**

(30) Priority: 30.12.2022 KR 20220190687
(71) Applicant: Samsung Electronics Co., Ltd., Suwon-si, Gyeonggi-do 16677 (KR)
(72) Inventor: Huang, Terrancechristopher, Suwon-si, Gyeonggi-do 16678 (KR); Kim, Youngjae, Suwon-si, Gyeonggi-do 16678 (KR)
(74) Representative: Grünecker Patent- und Rechtsanwälte PartG mbB

(57) **Abstract**

The battery system includes one or more respective battery packs each comprising at least one battery cell; monitoring circuitry; a slave controller; and a first circuit, wherein the first circuit comprises a first WPT system and a first converter circuit; a secondary circuit, wherein the secondary circuit comprises secondary WPT systems corresponding to each of the respective battery packs, with each secondary WPT system being configured to wirelessly transmit and receive power to and from the respective first WPT systems in the one or more respective battery packs and a second converter circuit; and a master controller.

## Description

### BACKGROUND

### 1. Field

The following description relates to methods and apparatuses with bi-directional wireless power transfer (WPT).

### 2. Description of Related Art

A battery system of an electric vehicle typically includes a battery pack, a battery management system (BMS) that monitors a state of battery cells in the battery pack and performs a function to protect the battery cells, a bus-bar that electrically connects to the battery cells, a wire to measure information such as voltage and temperature of the battery cells, and a wire harness including a wire for communication between BMSs.

### SUMMARY

This Summary is provided to introduce a selection of concepts in a simplified form that are further described below in the Detailed Description. This Summary is not intended to identify key features or essential features of the claimed subject matter, nor is it intended to be used as an aid in determining the scope of the claimed subject matter.

The invention is defined in the independent claims. Preferred embodiments are specified in the dependent claims.

In one general aspect, a battery system includes one or more respective battery packs each including at least one battery cell; monitoring circuitry; a slave controller; and a first circuit, wherein the first circuit comprises a first WPT system and a first converter circuit; a secondary circuit, wherein the secondary circuit comprises secondary WPT systems corresponding to each of the respective battery packs, with each secondary WPT system being configured to wirelessly transmit and receive power to and from the respective first WPT systems in the one or more respective battery packs and a second converter circuit; and a master controller.

The respective first WPT systems and the secondary WPT systems may each include a coil configured for wireless power transmission and reception and a switch circuit.

The monitoring circuitry may be configured to measure at least one of voltage, current, or temperature of the at least one battery cell.

The slave controller may be configured to determine whether one of the at least one battery cell is in an abnormal state based on at least one of a corresponding voltage, current, or temperature measured by the monitoring circuitry.

The slave controller may be configured to, in response to the at least one battery cell being in the abnormal state, transmit the abnormal state to the master controller.

The master controller may be configured to receive an indication that the at least one battery cell is in an abnormal state.

In response to the receipt of the indication, the master controller may be configured to generate a control signal to control the first circuit.

The master controller may be configured to transmit the control signal to a corresponding battery pack to control the first circuit of the corresponding battery pack.

The slave controller may be configured to receive the control signal to control the first circuit from the master controller.

The slave controller may be configured to control the first circuit based on the control signal.

The master controller may be configured to control the secondary circuit, to thereby change a connection configuration of the secondary circuit.

The first circuit and the secondary circuit may further each include a communication system used for wireless communication.

In another general aspect, a battery pack includes at least one battery cell; monitoring circuitry; a slave controller; and a first circuit, wherein the first circuit comprises respective first WPT systems and a first converter circuit, wherein the first WPT system is configured to wirelessly transmit and receive power to and from a secondary WPT system corresponding to the battery pack.

The first WPT system and the secondary WPT system may each include a coil configured for wireless power transmission and reception and a switch circuit.

The monitoring circuitry may be configured to measure at least one of voltage, current, or temperature of at least one battery cell.

The first circuit may further include a communication system for wireless communication.

In another general aspect, a method of managing a battery system, wherein the battery system includes a plurality of battery packs each including at least one battery cell; monitoring circuitry; a slave controller; and a first circuit, wherein the first circuit comprises a first wireless power transfer (WPT) system and a first converter circuit; a secondary circuit, wherein the secondary circuit comprises secondary WPT systems corresponding to each of the respective battery packs, with each secondary WPT system being configured to wirelessly transmit and receive power to and from the respective first WPT systems in the one or more respective battery packs and a second converter circuit; and a master controller, wherein the method includes receiving an indication of an abnormal state of a battery cell from a corresponding battery pack; generating a control signal by the master controller, in response to the indication of the abnormal state, to control the first circuit of the corresponding battery pack; and transmitting the control signal to the corresponding battery pack.

Other features and aspects will be apparent from the following detailed description, the drawings, and the claims.

### BRIEF DESCRIPTION OF THE DRAWINGS

FIG. 1 illustrates an example battery pack according to one or more embodiments.
FIG. 2 illustrates an example battery system according to one or more embodiments.
FIG. 3 illustrates an example wireless power transfer (WPT) system according to one or more embodiments.
FIG. 4 illustrates an example method of managing a battery system according to one or more embodiments.
FIG. 5 illustrates an example vehicle according to one or more embodiments.

Throughout the drawings and the detailed description, unless otherwise described or provided, the same drawing reference numerals may be understood to refer to the same or like elements, features, and structures. The drawings may not be to scale, and the relative size, proportions, and depiction of elements in the drawings may be exaggerated for clarity, illustration, and convenience.

### DETAILED DESCRIPTION

The following detailed description is provided to assist the reader in gaining a comprehensive understanding of the methods, apparatuses, and/or systems described herein. However, various changes, modifications, and equivalents of the methods, apparatuses, and/or systems described herein will be apparent after an understanding of the disclosure of this application. For example, the sequences of operations described herein are merely examples, and are not limited to those set forth herein, but may be changed as will be apparent after an understanding of the disclosure of this application, with the exception of operations necessarily occurring in a certain order. Also, descriptions of features that are known after an understanding of the disclosure of this application may be omitted for increased clarity and conciseness.

The features described herein may be embodied in different forms and are not to be construed as being limited to the examples described herein. Rather, the examples described herein have been provided merely to illustrate some of the many possible ways of implementing the methods, apparatuses, and/or systems described herein that will be apparent after an understanding of the disclosure of this application. The use of the term "may" herein with respect to an example or embodiment, e.g., as to what an example or embodiment may include or implement, means that at least one example or embodiment exists where such a feature is included or implemented, while all examples are not limited thereto.

The terminology used herein is for describing various examples only and is not to be used to limit the disclosure. The articles "a," "an," and "the" are intended to include the plural forms as well, unless the context clearly indicates otherwise. As non-limiting examples, terms "comprise" or "comprises," "include" or "includes," and "have" or "has" specify the presence of stated features, numbers, operations, members, elements, and/or combinations thereof, but do not preclude the presence or addition of one or more other features, numbers, operations, members, elements, and/or combinations thereof, or the alternate presence of an alternative stated features, numbers, operations, members, elements, and/or combinations thereof. Additionally, while one embodiment may set forth such terms "comprise" or "comprises," "include" or "includes," and "have" or "has" specify the presence of stated features, numbers, operations, members, elements, and/or combinations thereof, other embodiments may exist where one or more of the stated features, numbers, operations, members, elements, and/or combinations thereof are not present.

As used herein, the term "and/or" includes any one and any combination of any two or more of the associated listed items. The phrases "at least one of A, B, and C", "at least one of A, B, or C", and the like are intended to have disjunctive meanings, and these phrases "at least one of A, B, and C", "at least one of A, B, or C", and the like also include examples where there may be one or more of each of A, B, and/or C (e.g., any combination of one or more of each of A, B, and C), unless the corresponding description and embodiment necessitates such listings (e.g., "at least one of A, B, and C") to be interpreted to have a conjunctive meaning.

Throughout the specification, when a component or element is described as being "connected to," "coupled to," or "joined to" another component or element, it may be directly "connected to," "coupled to," or "joined to" the other component or element, or there may reasonably be one or more other components or elements intervening therebetween. When a component or element is described as being "directly connected to," "directly coupled to," or "directly joined to" another component or element, there can be no other elements intervening therebetween. Likewise, expressions, for example, "between" and "immediately between" and "adjacent to" and "immediately adjacent to" may also be construed as described in the foregoing. It is to be understood that if a component (e.g., a first component) is referred to, with or without the term "operatively" or "communicatively," as "coupled with," "coupled to," "connected with," or "connected to" another component (e.g., a second component), it means that the component may be coupled with the other component directly (e.g., by wire), wirelessly, or via a third component.

Although terms such as "first," "second," and "third", or A, B, (a), (b), and the like may be used herein to describe various members, components, regions, layers, or sections, these members, components, regions, layers, or sections are not to be limited by these terms. Each of these terminologies is not used to define an essence, order, or sequence of corresponding members, components, regions, layers, or sections, for example, but used merely to distinguish the corresponding members, components, regions, layers, or sections from other members, components, regions, layers, or sections. Thus, a first member, component, region, layer, or section referred to in the examples described herein may also be referred to as a second member, component, region, layer, or section without departing from the teachings of the examples.

Unless otherwise defined, all terms, including technical and scientific terms, used herein have the same meaning as commonly understood by one of ordinary skill in the art to which this disclosure pertains and based on an understanding of the disclosure of the present application. Terms, such as those defined in commonly used dictionaries, are to be interpreted as having a meaning that is consistent with their meaning in the context of the relevant art and the disclosure of the present application and are not to be interpreted in an idealized or overly formal sense unless expressly so defined herein.

In a typical battery park, the battery cells and elements operate wired communication between a slave BMS and a master BMS, and such an operation may increase complexity and weight in terms of the configuration of the typical battery pack. In response to an abnormal state such as a short circuit or capacity variation in the battery cells, a typical approach is to separate problematic battery cell(s) using an electrical switch on a typical wired system. In one or more embodiments, it is found to be beneficial to use an alternate battery pack and battery system, in which information sharing and control of the battery cells are implemented using wireless communication, thereby reducing manufacturing costs and optimizing the control of the battery cells and elements of the battery park.

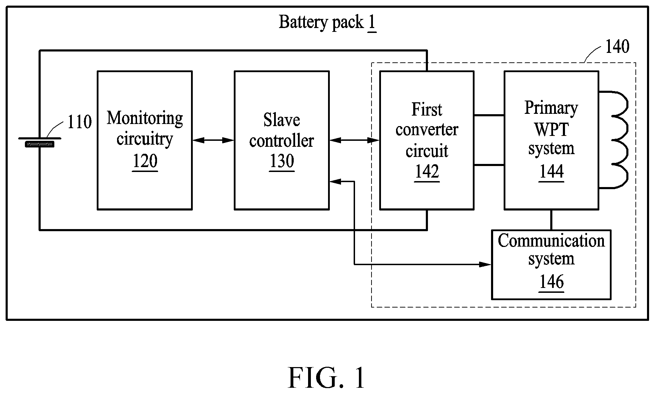

FIG. 1 illustrates an example battery pack according to one or more embodiments.

Referring to FIG. 1, an example battery pack 1 may include a battery cell 110, a primary circuit 140 connected to the battery cell 110, a monitoring circuitry 120, and a slave controller 130. The battery cell 110 may represent a nickel metal hydride battery or a lithium-ion battery that is rechargeable and dischargeable but is not limited thereto.

The primary circuit 140 may include a first converter circuit 142, a primary wireless power transfer (WPT) system 144, and a communication system 146.

The first converter circuit 142 may be configured to convert direct current (DC) power bi-directionally. As a non-limiting example, the first converter circuit 142 may include a bi-directional buck-boost DC-DC converter. When the battery cell 110 is charged, the first converter circuit 142 may convert DC power from the primary WPT system 144 in a direction of the battery cell 110. When the battery cell 110 is discharged, the first converter circuit 142 may convert DC power from the battery cell 110 in a direction of the primary WPT system 144. The first converter circuit 142 may be controlled by the slave controller 130 to output appropriate voltage or current.

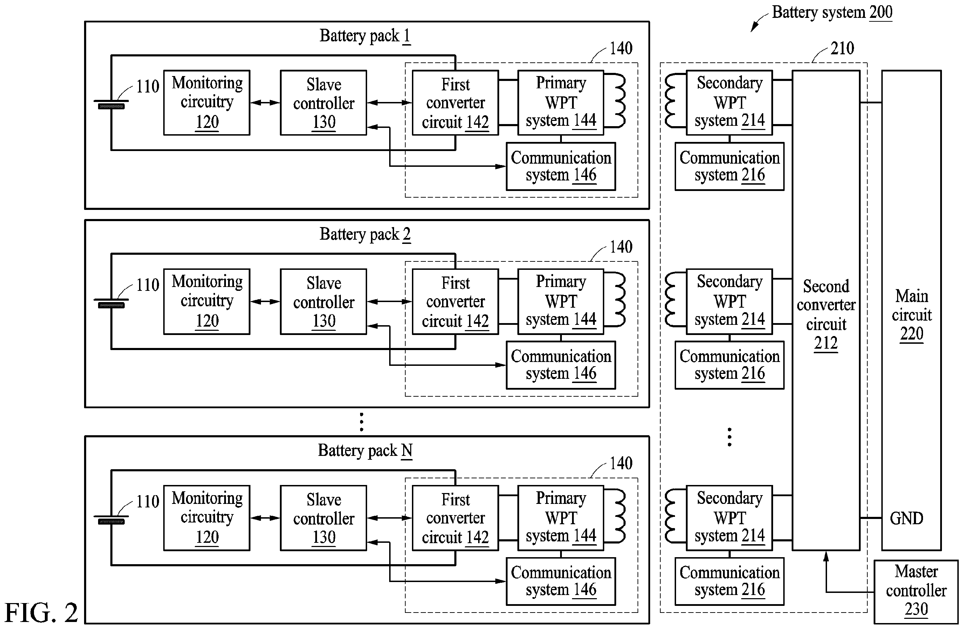

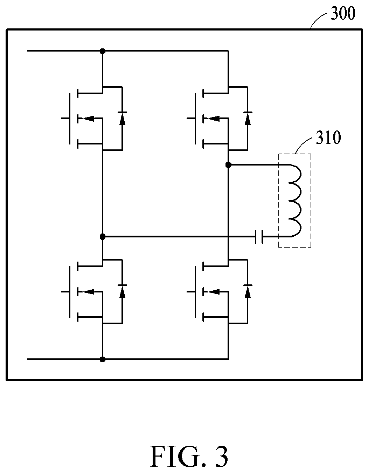

The primary WPT system 144 may be configured to convert DC power into alternating current (AC) power and/or to convertAC power into DC power bi-directionally. As a non-limiting example, the primary WPT system 144 may include a coil to wirelessly transmit and receive power and a switch circuit. In FIGS. 1 and 2, the coil is shown on the right side of the primary WPT system 144 for understanding bi-directional power transmission and reception. When the battery cell 110 is charged, the primary WPT system 144 may convert AC power wirelessly applied from outside of the battery pack 1 in a direction of the first converter circuit 142 through the coil into DC power. When the battery cell 110 is discharged, the primary WPT system 144 may convert DC power into AC power so that the AC power is applied from the first converter circuit 142 to the outside of the battery pack 1 through the coil. The primary WPT system 144 is described below with reference to FIG. 3.

The communication system 146 may be configured to perform information communication and signal transmission on the slave controller 130 of the battery pack 1. As a non-limiting example, the communication system 146 may be matched to the primary WPT system 144. The communication system 146 may transmit and receive information or signals to and from an external device (e.g., a communication system 216 of FIG. 2) by controlling an envelope of power that is transmitted and received using the coil of the primary WPT system 144. As a non-limiting example, the communication system 146 may include a circuit or an element for detecting an envelope of a wireless power signal modulated (e.g., encoded) according to information and decoding the information based on the detected envelope.

Although the communication system 146 is included in the primary circuit 140 as shown in FIG. 1 for example, the communication system 146 may be configured not to be integrated into the primary circuit 140. The communication system 146 may include an antenna that transmits and receives radio signals and an integrated circuit (IC) chip (or tag). As a non-limiting example, the communication system 146 may include near field communication (NFC) or an antenna for radio frequency (RF) communication such as high frequency (HF) and very high frequency (VHF). The communication system 146 may communicate with the slave controller 130. The slave controller 130 may wirelessly communicate with a master controller (e.g., a master controller 230 of a battery system 200 in FIG. 2) using the communication system 146.

The monitoring circuitry 120 may be configured to measure at least one of voltage, current, or temperature of the battery cell 110 of the battery pack 1. As a non-limiting example, the monitoring circuitry 120 may transmit the measured voltage, current, or temperature of the battery cell 110 to the slave controller 130, which may utilize the measured voltage, current, or temperature of the battery cell 110 to diagnose a state of the battery cell 110. Herein, each of the controllers, WPT systems, communication systems, and monitoring circuitry may include at least one processing circuit including hardware elements. The WPT systems may include power transmission and/or power reception coils, and may further include AC to DC converters and DC to AC convertors. The communication systems may include transceiver circuitry, e.g., for wireless communication. The communication systems may also include transceiver circuitry configured for wired communication. In a non-limiting example, the wireless and/or wired communications may comply with respective international standard communication protocols, though examples include wired and/or wireless communication that is different from and does not comply with such international standard communication protocols.

The slave controller 130 may include a slave battery management system (BMS). The slave controller 130 may be configured to control all components of the battery pack 1 including the first converter circuit 142 and the primary WPT system 144. As a non-limiting example, the slave controller 130 may estimate respective parameters such as a state of charge (SoC) and a state of health (SoH) of the battery cell 110 and may prevent the battery cell 110 from being overcharged or overdischarged. The slave controller 130 may include wired/wireless communication systems or elements for respective wired/wireless communications. The slave controller 130 may thus diagnose a state of the battery cell 110.

The slave controller 130 may receive the voltage, current, or temperature of the battery cell 110 measured by the monitoring circuitry 120. The slave controller 130 may determine whether a state of the battery cell 110 corresponds to a predetermined abnormal state based on at least one of the voltage, current, or temperature of the battery cell 110. As a non-limiting example, when the voltage, current, or temperature of the battery cell 110 measured by the monitoring circuitry 120 is less than or exceeds a predetermined threshold voltage, threshold current, or threshold temperature, the slave controller 130 may determine that the battery cell 110 is in an abnormal state, e.g., that the state has changed from a previously determined normal state.

The slave controller 130 may be configured to control the primary circuit 140 based on a control signal (e.g., from a master controller 230 of a battery system 200 in FIG. 2). As a non-limiting example, the slave controller 130 may control the primary WPT system 144 to block wireless power transmission and reception of the primary WPT system 144 when the battery cell 110 is determined to be in an abnormal state, for example. The slave controller 130 may control the first converter circuit 142 by, for example, disabling the first converter circuit 142. Thus, the slave controller 130 may perform an operation such as power transmission bypass of a cell-unit battery pack by controlling the primary circuit 140.

FIG. 2 illustrates an example battery system having one or more battery packs according to one or more embodiments.

An example battery system 200 may include a plurality (e.g., N) of battery packs 1 through N, a secondary circuit 210, a main circuit 220, and a master controller 230.

The description of the battery pack 1 described with respect to FIG. 1 may apply to the description of the battery packs 1 through N with respect to FIG. 2.

The secondary circuit 210 may include a second converter circuit 212, one or more secondary WPT system 214s, and one or more communication systems 216.

The main circuit 220 may represent a load or a charger. As a non-limiting example, the main circuit 220 may supply power for charging the battery packs 1 through N to the second converter circuit 212 or may receive power from the second converter circuit 212.

The second converter circuit 212 may be configured to convert DC power bi-directionally. As a non-limiting example, the second converter circuit 212 may represent a bi-directional buck-boost DC-DC converter. When the battery cell 110 is charged, the second converter circuit 212 may convert DC power from the main circuit 220 in a direction of a corresponding secondary WPT system 214. When the battery cell 110 is discharged, the second converter circuit 212 may convert DC power from the corresponding secondary WPT system 214 in a direction of the main circuit 220.

The second converter circuit 212 may represent multiple input (or output) converter circuits. As a non-limiting example, the second converter circuit 212 may include a plurality of converter circuits for a plurality of secondary WPT systems 214 corresponding to the plurality of battery packs 1 through N, respectively. The plurality of converter circuits may be connected in series. The second converter circuit 212 may output voltage or current required by the main circuit 220 by changing a connection configuration between the plurality of converter circuits.

Each secondary WPT system 214 may convert DC power into AC power or AC power into DC power bi-directionally. As a non-limiting example, a secondary WPT system 214 may include a coil to wirelessly transmit and receive power and a switch circuit. For convenience of description of bi-directional power transmission and reception, the coil is shown on the left side of the secondary WPT system 214. When a battery cell 110 is charged, the secondary WPT system 214 may convert DC power into AC power so that the AC power is applied from the second converter circuit 212 in the direction of the primary WPT system 144 of a corresponding one of the battery packs 1, 2, and N through the coil. When the battery cell 110 is discharged, the secondary WPT system 214 may convert AC power wirelessly applied from the primary WPT system 144 of the corresponding one of the battery packs 1, 2, and N through the coil into DC power in a direction of the second converter circuit 212.

Each communication system 216 may perform information communication and signal transmission between the slave controller 130 of a corresponding one of the battery packs 1 through N and the master controller 230. As a non-limiting example, a communication system 216 may be matched to a corresponding secondary WPT systems 214. The communication system 216 may transmit and receive information or signals to and from the corresponding one of the battery packs 1 through N by controlling an envelope of power that is transmitted and received using the coil of the corresponding secondary WPT system 214. For example, the communication system 216 may include a circuit or an element for detecting an envelope of a wireless power signal modulated (e.g., encoded) according to information and decoding the information based on the detected envelope.

Although the communication system 216 is included in the secondary circuit 210 as shown in FIG. 2, the communication system 216 may be configured not to be integrated into the secondary circuit 210. As a non-limiting example, the communication system 216 may include an antenna for transmitting and receiving radio signals and an IC chip (or tag). For example, the communication system 216 may include NFC or an antenna for RF communication such as HF and VHF.

The master controller 230 may include a master BMS. As a non-limiting example, when the master BMS detects and determines respective states of the battery packs 1 through N (e.g., routinely), and may determine that a corresponding one of the battery packs 1 through N is in an abnormal state, the master controller 230 may receive an indication of the abnormal state from the corresponding battery pack. The master controller 230 may generate a control signal, in response to the received abnormal state indication, to control the primary circuit 140 of the corresponding battery pack and transmit the control signal to the corresponding battery pack.

The master controller 230 may be configured to control the secondary circuit 210 to, for example, change a connection configuration of the secondary circuit 210. As a non-limiting example, the master controller 230 may control the secondary circuit 210 to change any one of or both connection configurations of the second converter circuit 212 and the secondary WPT system 214.

For example, the master controller 230 may receive an indication of the abnormal state of the battery cell 110 of the battery pack 1 from the battery pack 1 (or the slave controller 130 of the battery pack 1). The master controller 230 may generate the control signal, in response to the received abnormal state indication, to control the primary circuit 140 of the battery pack 1. The control signal may serve to control the primary WPT system 144 and/or the first converter circuit 142 of the battery pack 1 where the battery cell 110 is in an abnormal state. The control signal may also serve to control the primary WPT system 144 to block wireless power transmission and reception. The control signal may also serve to disable the first converter circuit 142. The master controller 230 may transmit the control signal to the battery pack 1 (or the slave controller 130 of the battery pack 1) through the communication system 146. The master controller 230 may thus control the secondary WPT system 214 corresponding to the battery pack 1 to block wireless power transmission and reception.

In an example, the master controller 230 may control the connection configuration of the second converter circuit 212 to supplementally receive a shortfall of power that may not be received from the battery pack 1 from the remaining battery packs 2 through N. The master controller 230 may transmit the control signal to adjust the size of power wirelessly received by the secondary circuit 210 to the remaining battery packs 2 through N. As a non-limiting example, the respective slave controllers 130 of the remaining battery packs 2 through N that receive the control signal from the master controller 230 may increase the size of power to be wirelessly transmitted to the respective secondary WPT systems 214 through the respective primary WPT systems 144 of the remaining battery packs 2 through N.

FIG. 3 illustrates an example WPT system according to one or more embodiments.

An example WPT system 300 (e.g., the primary WPT system 144 of FIGS. 1 and 2 or the secondary WPT system 214 of FIG. 2) may include a coil 310 to wirelessly transmit and receive power and a switch circuit.

The coil 310 may be used to transmit and receive information or signals by a communication system (e.g., the communication system 146 or the communication system 216 of FIG. 2).

The WPT system 300 may be configured to convert DC-AC power bi-directionally. When AC power is applied to the WPT system 300, a magnetic field of the coil 310 may be changed. As a non-limiting example, when AC power is applied to the coil of the secondary WPT system 214, the magnetic field of the coil may be changed, and as a result, the magnetic field of the coil in the corresponding primary WPT system 144 may be changed. By converting AC voltage applied by the change in the magnetic field of the coil in the primary WPT system 144 into DC voltage using the switch circuit, a battery cell (e.g., the battery cell 110 of FIGS. 1 and 2) may be charged.

When a battery cell 110 of any one of the battery packs 1 through N is determined to be in an abnormal state, a slave controller (e.g., the slave controller 130 of FIGS. 1 and 2) may, based on a control signal, control the primary circuit (e.g., the primary circuit 140 of FIGS. 1 and 2). The slave controller may control the WPT system 300 (or the primary WPT system 144) based on the control signal. As a non-limiting example, the slave controller may control the WPT system to block wireless power transmission and reception by turning off a switch in a switch circuit of the WPT system in the battery pack including the battery cell in an abnormal state.

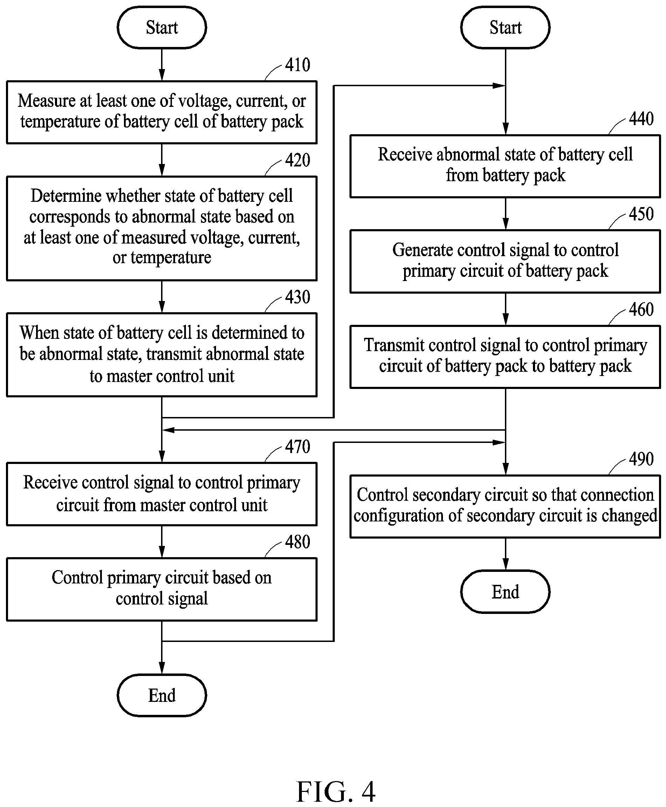

FIG. 4 illustrates an example method of managing a battery system according to one or more embodiments.

As shown in FIG. 4, the example method may include operations 410 through 490, which may be performed in the shown order and manner. However, the order of some operations may be changed, or some operations may be omitted, without departing from the scope of the shown example. Many of the operations shown in FIG. 4 may be performed in parallel, concurrently, or any suitable order that may optimize the methods/operations described herein.

Operation 410 may be performed by a monitoring circuitry (e.g., the monitoring circuitry 120 of FIGS. 1 and 2) of a battery pack (e.g., the battery pack 1 of FIG. 1). Operations 420, 430, 470, and 480 may be performed by a slave controller (e.g., the slave controller 130 of FIGS. 1 and 2) of the battery pack. Operations 440 through 460 and 490 may be performed by a master controller (e.g., the master controller 230 of FIG. 2).

In operation 410, the monitoring circuitry may measure at least one of voltage, current, or temperature of the battery cell in each of the battery packs (e.g., the battery packs 1 through N in FIG. 2). The monitoring circuitry may transmit the measured voltage, current, or temperature of the battery cell to the slave controller.

In operation 420, the slave controller may determine whether the battery cell is in an abnormal state based on at least one of the measured voltage, current, or temperature. As a non-limiting example, when the voltage, current, or temperature of the battery cell measured by the monitoring circuitry is less than or exceeds a predetermined threshold voltage, threshold current, or threshold temperature, the slave controller may determine that the battery cell is in an abnormal state.

In operation 430, when the battery cell is determined to be in an abnormal state, the slave controller may transmit an indication of the abnormal state to the master controller. As a non-limiting example, the slave controller may transmit a signal representing the abnormal state of the battery cell to the master controller through a communication system (e.g., the communication system 146 in FIGS. 1 and 2) of the battery pack.

In operation 440, the master controller may receive the indication of the abnormal state of the battery cell from the battery pack. As a non-limiting example, the master controller may receive the indication of the abnormal state of the battery cell from the slave controller of the battery park including the battery cell that is in the abnormal state.

In operation 450, the master controller may generate a control signal to control a primary circuit (e.g., the primary circuit 140 in FIGS. 1 and 2) of the battery pack including the battery cell that is in the abnormal state.

The control signal may represent a signal to control a primary WPT system (e.g., the primary WPT system 144 in FIGS. 1 and 2) and/or a first converter circuit (e.g., the first convert 142 in FIGS. 1 and 2) of the battery pack including the battery cell that is in an abnormal state. As a non-limiting example, the control signal may serve to control the primary WPT system to block wireless power transmission and reception, and may also serve to disable the first converter circuit, when it is determined that the battery cell of the battery pack is in an abnormal state.

In operation 460, the master controller may transmit the control signal to control the primary circuit of the battery pack to the battery pack. As a non-limiting example, the master controller may transmit the control signal to the slave controller of the battery pack through the communication system of the battery pack.

In operation 470, the slave controller may receive the control signal to control the primary circuit from the master controller.

In operation 480, the slave controller may control the primary circuit based on the control signal. The slave controller may control the primary WPT system of the battery park to block wireless power transmission and reception of the primary WPT system of the battery pack when the battery cell of the battery park is determined to be in an abnormal state. For example, the slave controller may control the primary WPT system to block wireless power transmission and reception by turning off a switch in a switch circuit of the primary WPT system. The slave controller may also control the first converter circuit to disable the first converter circuit.

In operation 490, the master controller may control a secondary circuit (e.g., the secondary circuit 210 in FIG. 2) to change a connection configuration of the secondary circuit.

The master controller may control a secondary WPT system (e.g., the secondary WPT system 214 in FIG. 2) corresponding to the battery pack including the abnormal battery cell to block wireless power transmission and reception. The master controller may control a second converter circuit (e.g., the second converter circuit 212 in FIG. 2) to change a connection configuration of the second converter circuit to supplementally receive a shortfall of power, which may not be received from the battery pack including the abnormal battery cell, from remaining battery packs.

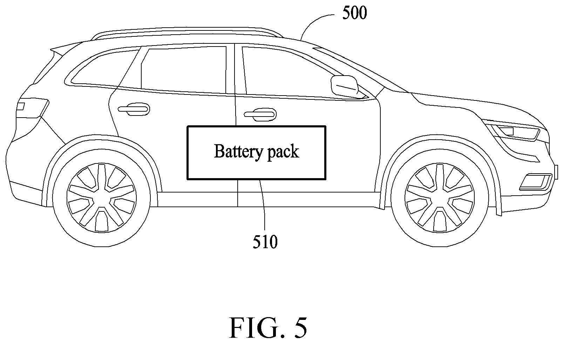

FIG. 5 illustrates an example vehicle according to one or more embodiments.

Referring to FIG. 5, a vehicle 500 may include a battery pack 510 (e.g., the battery pack 1 of FIG. 1). As a non-limiting example, the battery pack 510 may include a plurality of battery packs (e.g., the plurality of battery packs 1 through N of FIG. 2). The vehicle 500 may be a vehicle using the battery pack 510 as a power source. The vehicle 500 may be, for example, an electric vehicle or a hybrid vehicle.

The vehicle 500 may include the battery pack 510 and a battery system (e.g., the battery system 200 of FIG. 2) including the battery pack 510. The battery system may monitor whether an abnormality occurs in the battery pack 510 and prevent the battery pack 510 from being overcharged or overdischarged. The battery system may perform thermal control on the battery pack 510 when a temperature of the battery pack 510 exceeds a first predetermined temperature (e.g., 40 degrees Celsius (°C)) or is less than a second predetermined temperature (e.g., -10 °C). In addition, the battery system may allow an SoC between battery cells to be equalized in the battery pack 510 by performing cell balancing on the battery pack 510.

The description provided with reference to FIGS. 1 through 4 may apply to the description of FIG. 5, and thus, a detailed description thereof is omitted.

The processors, memories, electronic devices, apparatuses, circuits, WPT systems, communication systems, monitoring circuitries, master and slave controllers, BMS, battery packs, and other apparatuses, devices, and components described herein with respect to FIGS. 1-5 are implemented by or representative of hardware components. Examples of hardware components that may be used to perform the operations described in this application where appropriate include controllers, sensors, generators, drivers, memories, comparators, arithmetic logic units, adders, subtractors, multipliers, dividers, integrators, and any other electronic components configured to perform the operations described in this application. In other examples, one or more of the hardware components that perform the operations described in this application are implemented by computing hardware, for example, by one or more processors or computers. A processor or computer may be implemented by one or more processing elements, such as an array of logic gates, a controller and an arithmetic logic unit, a digital signal processor, a microcomputer, a programmable logic controller, a field-programmable gate array, a programmable logic array, a microprocessor, or any other device or combination of devices that is configured to respond to and execute instructions in a defined manner to achieve a desired result. In one example, a processor or computer includes, or is connected to, one or more memories storing instructions or software that are executed by the processor or computer. Hardware components implemented by a processor or computer may execute instructions or software, such as an operating system (OS) and one or more software applications that run on the OS, to perform the operations described in this application. The hardware components may also access, manipulate, process, create, and store data in response to execution of the instructions or software. For simplicity, the singular term "processor" or "computer" may be used in the description of the examples described in this application, but in other examples multiple processors or computers may be used, or a processor or computer may include multiple processing elements, or multiple types of processing elements, or both. For example, a single hardware component or two or more hardware components may be implemented by a single processor, or two or more processors, or a processor and a controller. One or more hardware components may be implemented by one or more processors, or a processor and a controller, and one or more other hardware components may be implemented by one or more other processors, or another processor and another controller. One or more processors, or a processor and a controller, may implement a single hardware component, or two or more hardware components. A hardware component may have any one or more of different processing configurations, examples of which include a single processor, independent processors, parallel processors, single-instruction single-data (SISD) multiprocessing, single-instruction multiple-data (SIMD) multiprocessing, multiple-instruction single-data (MISD) multiprocessing, and multiple-instruction multiple-data (MIMD) multiprocessing.

The methods illustrated in FIGS. 1-5 that perform the operations described in this application are performed by computing hardware, for example, by one or more processors or computers, implemented as described above implementing instructions or software to perform the operations described in this application that are performed by the methods. For example, a single operation or two or more operations may be performed by a single processor, or two or more processors, or a processor and a controller. One or more operations may be performed by one or more processors, or a processor and a controller, and one or more other operations may be performed by one or more other processors, or another processor and another controller. One or more processors, or a processor and a controller, may perform a single operation, or two or more operations.

Instructions or software to control computing hardware, for example, one or more processors or computers, to implement the hardware components and perform the methods as described above may be written as computer programs, code segments, instructions or any combination thereof, for individually or collectively instructing or configuring the one or more processors or computers to operate as a machine or special-purpose computer to perform the operations that are performed by the hardware components and the methods as described above. In one example, the instructions or software include machine code that is directly executed by the one or more processors or computers, such as machine code produced by a compiler. In another example, the instructions or software includes higher-level code that is executed by the one or more processors or computer using an interpreter. The instructions or software may be written using any programming language based on the block diagrams and the flow charts illustrated in the drawings and the corresponding descriptions herein, which disclose algorithms for performing the operations that are performed by the hardware components and the methods as described above.

The instructions or software to control computing hardware, for example, one or more processors or computers, to implement the hardware components and perform the methods as described above, and any associated data, data files, and data structures, may be recorded, stored, or fixed in or on one or more non-transitory computer-readable storage media. Examples of a non-transitory computer-readable storage medium include read-only memory (ROM), random-access programmable read only memory (PROM), electrically erasable programmable read-only memory (EEPROM), random-access memory (RAM), dynamic random access memory (DRAM), static random access memory (SRAM), flash memory, non-volatile memory, CD-ROMs, CD-Rs, CD+Rs, CD-RWs, CD+RWs, DVD-ROMs, DVD- Rs, DVD+Rs, DVD-RWs, DVD+RWs, DVD-RAMs, BD-ROMs, BD-Rs, BD-R LTHs, BD-REs, blue-ray or optical disk storage, hard disk drive (HDD), solid state drive (SSD), flash memory, a card type memory such as multimedia card micro or a card (for example, secure digital (SD) or extreme digital (XD)), magnetic tapes, floppy disks, magneto-optical data storage devices, optical data storage devices, hard disks, solid-state disks, and any other device that is configured to store the instructions or software and any associated data, data files, and data structures in a non-transitory manner and provide the instructions or software and any associated data, data files, and data structures to one or more processors or computers so that the one or more processors or computers can execute the instructions. In one example, the instructions or software and any associated data, data files, and data structures are distributed over network-coupled computer systems so that the instructions and software and any associated data, data files, and data structures are stored, accessed, and executed in a distributed fashion by the one or more processors or computers.

While this disclosure includes specific examples, it will be apparent after an understanding of the disclosure of this application that various changes in form and details may be made in these examples without departing from the scope of the claims. The examples described herein are to be considered in a descriptive sense only, and not for purposes of limitation. Descriptions of features or aspects in each example are to be considered as being applicable to similar features or aspects in other examples. Suitable results may be achieved if the described techniques are performed in a different order, and/or if components in a described system, architecture, device, or circuit are combined in a different manner, and/or replaced or supplemented by other components or their equivalents.

Therefore, in addition to the above disclosure, the scope of the invention is defined by the enclosed claims.

## Claims

1. A battery pack, comprising:
at least one battery cell;
monitoring circuitry;
a slave controller; and
a first circuit, wherein the first circuit comprises respective first wireless power transfer, WPT, systems and a first converter circuit,
wherein the first WPT system is configured to wirelessly transmit and receive power to and from a secondary WPT system corresponding to the battery pack.

2. The battery pack of claim 1, wherein the first WPT system and the secondary WPT system each comprise a coil configured for wireless power transmission and reception and a switch circuit.

3. The battery pack of claim 1 or 2, wherein the monitoring circuitry is configured to measure at least one of voltage, current, or temperature of at least one battery cell.

4. The battery pack of one of claims 1 to 3, wherein the first circuit further comprises a communication system for wireless communication.

5. A battery system, comprising:
one or more respective battery packs of one of claims 1 to 4;
a secondary circuit, wherein the secondary circuit comprises secondary WPT systems corresponding to each of the respective battery packs, with each secondary WPT system being configured to wirelessly transmit and receive power to and from the respective first WPT systems in the one or more respective battery packs and a second converter circuit; and
a master controller.

6. The battery system of claim 5, wherein the slave controller is configured to:
determine whether one of the at least one battery cell is in an abnormal state based on at least one of a corresponding voltage, current, or temperature measured by the monitoring circuitry, and
transmit the abnormal state to the master controller, in response to the at least one battery cell being in the abnormal state.

7. The battery system of claim 5 or 6, wherein the master controller is configured to:
receive an indication that the at least one battery cell is in an abnormal state, and generate a control signal to control the first circuit, in response to the receipt of the indication.

8. The battery system of claim 7, wherein the master controller is configured to transmit the control signal to a corresponding battery pack to control the first circuit of the corresponding battery pack.

9. The battery system of claim 8, wherein the slave controller is configured to receive the control signal to control the first circuit from the master controller.

10. The battery system of claim 9, wherein the slave controller is configured to control the first circuit based on the control signal.

11. The battery system of one of claims 5 to 10, wherein the master controller is configured to control the secondary circuit, to thereby change a connection configuration of the secondary circuit.

12. The battery system of one of claims 5 to 11, wherein the first circuit and the secondary circuit further each comprise a communication system used for wireless communication.

13. A method of managing a battery system, wherein the battery system comprises:
a plurality of battery packs each comprising:
at least one battery cell;
monitoring circuitry;
a slave controller; and
a first circuit, wherein the first circuit comprises a first wireless power transfer, WPT, system and a first converter circuit;
a secondary circuit, wherein the secondary circuit comprises secondary WPT systems corresponding to each of the respective battery packs, with each secondary WPT system being configured to wirelessly transmit and receive power to and from the respective first WPT systems in the one or more respective battery packs and a second converter circuit; and
a master controller,
wherein the method comprises:
receiving an indication of an abnormal state of a battery cell from a corresponding battery pack;
generating a control signal by the master controller, in response to the indication of the abnormal state, to control the first circuit of the corresponding battery pack; and
transmitting the control signal to the corresponding battery pack.

14. The method of claim 13, wherein the monitoring circuitry is configured to measure at least one of voltage, current, or temperature of at least one battery cell, and wherein the slave controller is configured to:
determine whether one of the at least one battery cell is in an abnormal state based on at least one of a corresponding voltage, current, or temperature measured by the monitoring circuitry;
in response to the battery cell being in the abnormal state, transmit the abnormal state to the master controller;
and
control the first circuit based on the control signal from the master controller.

15. The method of claim 13 or 14, further comprising:
controlling the secondary circuit to change a connection configuration of the secondary circuit.
